Europäisches Patentamt

European Patent Office

Office européen des brevets

(11) Publication number: **0 095 384**
**A2**

(12) **EUROPEAN PATENT APPLICATION**

(21) Application number: **83303014.1**

(22) Date of filing: **25.05.83**

(51) Int. Cl.³: **C 23 C 13/08**

(30) Priority: **26.05.82 JP 89287/82**
**26.05.82 JP 89288/82**

(43) Date of publication of application:
**30.11.83 Bulletin 83/48**

(84) Designated Contracting States:
**DE FR GB**

(71) Applicant: **KONISHIROKU PHOTO INDUSTRY CO. LTD.**
**No. 1 Sakura-machi**
**Hino-shi Tokyo(JP)**

(72) Inventor: **Shindo, Masanari**
**1001-21 Nishiterakata-machi**
**Hachioji-shi Tokyo(JP)**

(72) Inventor: **Sato, Shigeru**
**3-15-10 Minamidaira**
**Hino-shi Tokyo(JP)**

(72) Inventor: **Mano, Shigeru**
**4-29-3 Noguchi-cho**
**Higashimurayama-shi Tokyo(JP)**

(74) Representative: **Senior, Alan Murray et al,**
**J.A. KEMP & CO 14 South Square Gray's Inn**
**London WC1R 5EU(GB)**

(54) Vacuum deposition apparatus.

(57) The invention provides vaccum deposition apparatus including a chamber (3), a vapor source (2), a deposition substrate (1) opposite to the vapor source (2) and an inlet (6) for a modifying gas, wherein in use the vapor source (2) is heated in the presence of a modifying gas to be deposited onto the substrate, characterized by an electron-beam supplying device (10,40) for emitting an electron-beam toward the substrate (1). The supply of electrons ionizes the gas only near the film surface being deposited thus allowing more even introduction.

FIG. I

MODIFYING GAS →

VACUUM PUMP

EP 0 095 384 A2

Croydon Printing Company Ltd

- 1 -

## VACUUM DEPOSITION APPARATUS

The present invention relates to vacuum deposition apparatus.

Amorphous silicon (hereinafter referred to as "a-Si") has recently become regarded as an extremely useful constituent material for solar batteries and electrophotosensitive receptors amongst other uses. Further, hydrogen-containing a-Si (hereinafter referred to as "a-Si:H") has become known, this having a dark-conductivity and a photoconductivity which are improved by introducing into a-Si hydrogen atoms that take up free bonds of a-Si.

The following evaporation methods have so far been employed for depositing a-Si:H on a substrate.

(1)   Rf ion-plating method

(2)   DC ion-plating method

(3)   Ionized- or activated-hydrogen-introduction method (e.g. Japanese Patent Publication Open to Public Inspection No  78413/1981)

(a)   A hydrogen-discharge tube is used.

(b)   A DC ion gun is used.

(c)   An Rf ion gun is used.

All of the vacuum deposition equipment for performing the above methods (1) - (3), wherein

- 2 -

silicon is heated and evaporated in the presence of activated or ionized hydrogen in a vacuum deposition chamber or in a vacuum chamber (a bell jar) are basically based on the following concept. Namely, activated or ionized hydrogen is introduced into the bell jar, or at least one of hydrogen and silicon vapor is discharged through the Rf electric field or the DC electric field and thereby is activated.

However, it has been found that all of the known vacuum deposition equipment raises problems and has drawbacks. First of all, in the equipment employing the foregoing method (1), glow discharge takes place substantially over the entire space in the bell jar and therefore, a chemical element (e.g. P) isolated previously from an impurity gas (e.g. $PH_3$) are deposited on the inner surface of the bell jar etc. evaporates again at the time of the glow discharge and gets mixed with the a-Si:H deposited on the substrate, causing film contamination. In the equipment employing the method (2), thermoelectrons are emitted from the W-electrode towards the silicon vapor and thereby silicon is ionized above the silicon vapor source, so that an arc discharge tends to take place between the foregoing electrode and the opposing electrode for electron-suction, which causes unstable discharging and film contamination caused by impurities at the time of discharge in the same manner as what is described above. Further, in the equipment employing the foregoing method (3), hydrogen ions produced in the discharge tube are emitted towards the substrate and it is possible to introduce a great amount of hydrogen atoms into the a-Si film, but the amount introduced varies over the surface of the substrate and the problem of unevenness arises in that the distribution of hydrogen ions is large at the center of the substrate and is small on the peripheral area. To solve such a problem, it is proposed for hydrogen ions to be supplied into the bell jar and deflected by deflecting means so as evenly to scan the surface of the substrate but it is not so easy to deflect the hydrogen ions and an arc discharge tends to take place as well because a high voltage is needed.

According to the present invention there is provided vacuum deposition apparatus including a chamber, a vapor source, a deposition substrate opposite to the vapor source and an inlet for a modifying gas, wherein in use the vapor source is heated in the presence of a modifying gas to be deposited onto the substrate, characterized by an electron-beam supplying device for emitting an electron-beam toward the substrate.

- 4 -

The present invention also provides a vacuum deposition method for formation of a layer wherein a vapor source is heated in the presence of a modifying gas to be deposited onto a substrate opposite to the vapor source, characterized in that an electron-beam is generated and directed toward the substrate.

It is found that the present invention enables one to introduce stably, easily and evenly the modifying gas such as the aforesaid hydrogen ions etc. into the evaporated film, which preferably though not necessarily is of silicon and also enables reduction of film contamination.

With apparatus of the invention, the modifying gases such as hydrogen or the like may be supplied widely into the vacuum deposition chamber so as to be kept intact (without being activated or ionized) and are effectively activated or ionized only in the vicinity of the substrate by the electron beam emitted toward the substrate so that they can be introduced evenly into the evaporated film of, for instance, a-Si. That is, the modifying gases can be distributed uniformly in the vicinity of the substrate and they are excited by the easily-deflectable and controllable electron beam and thus the gas components can be incorporated uniformly in the evaporated film. Moreover, since the excitation takes place in the vicinity of the substrate, activated or ionized modifying gases can effectively reach the substrate despite the short excitation life of the modifying gas and contamination of the evaporated film can be reduced compared with the prior art. Further, since it is possible to supply the intact modifying gas into the vacuum deposition chamber, it is not necessary to use the discharge tube for activating or ionizing the gas and therefore, it is possible to prevent the sputtering (e.g. the emission of the material of the discharge electrode) that occurs when a discharge tube is used and also it is possible to prevent contamination and damage of the discharge tube (e.g. contamination or damage caused by the decomposition of halogen gas such as fluorine or the like) caused by the decomposition of the gas even if various gases are supplied.

For particularly advantageous effects it is preferable, from the viewpoint of improving the efficiency, to apply a negative voltage, most preferably a D.C. voltage of 0 to -10 KV, to the substrate and thus attract the ions produced in the vicinity of the substrate toward the substrate. Further, the electron beams to be emitted toward the substrate should preferably be generated from a thermoelectron

- 6 -

generator with W- electrodes and the like arranged inside or outside the vacuum deposition chamber, or they may be emitted selectively from a gas discharge tube arranged in the same position according to circumstances. Furthermore, it is preferable to provide an accelerating device for accelerating the electron beam emitted from the electron-beam supplying device and preferably also a magnetic field deflecting device for deflecting the electron beam and guiding it toward the substrate. Further, in order to apply electron beams evenly over the surface of the substrate, it is preferable to provide a magnetic field deflecting device or an electric field deflecting device for changing (or vibrating) the path of electron beams toward the substrate and thereby scanning evenly the surface of the substrate.

In order that the invention may be more clearly understood the following description is given by way of example only with reference to the accompanying drawings in which:

Fig 1 is a schematic sectional view of a vacuum deposition equipment,

Fig 2 is a schematic view showing the state of activation or ionization of modifying gases in the vicinity of the substrate,

- 7 -

Fig 3 is a perspective view showing schematically a thermoelectron generator, its accelerating electrode and a deflecting device,

Fig 4 is a perspective view showing schematically another thermoelectron generator and its accelerating electrode,

Fig. 5 is a perspective view showing schematically further thermoelectron generator,

Fig. 6 is a graph showing the change of photoelectric characteristic of the vacuum-deposited film caused by the substrate voltage,

Fig. 7 is a graph showing the change of the electron current to flow in caused by the substrate voltage,

Fig. 8 is an enlarged sectional view of the primary portion of the element obtained from the vacuum deposition,

Fig. 9 is a sectional view showing schematically the layout state of thermoelectron generator and its deflecting device in another example,

Fig. 10 is a schematic sectional view of the vacuum deposition equipment in further example and

Fig. 11 is an enlarged sectional view of the thermoelectron generator in Fig. 10.

DETAILED DESCRIPTION OF THE INVENTION

The present invention will be described in detail as follows regarding the examples shown in the drawings.

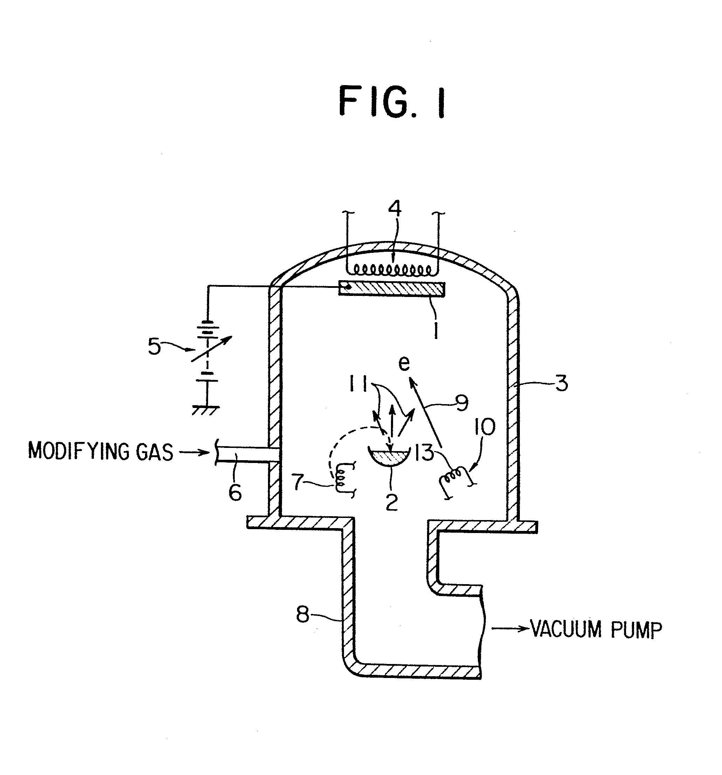

Fig. 1 shows schematically an example of the structure of the vacuum deposition equipment of the present invention.

This vacuum deposition equipment is equipped with a vacuum deposition chamber 3 (that is, a bell jar) comprising the substrate 1 and, for example, the silicon vapor source 2. The substrate 1 is heated by the heater 4 up to 350 - 450°C, while negative DC bias voltage of 0 to -10 KV is impressed on the substrate from the DC power source 5. In the drawing, 6 is an introducing pipe for introducing the modifying gas such as hydrogen or the like, 7 is an electron-beam heating device (the path of electron-beam is shown with a dotted line) for heating the evaporation source 2 and 8 is an exhaust pipe which is connected to the vacuum pump (unillustrated). What is noticeable here is that the thermoelectron generator 10 (e.g. the one having W-filament electrode 13) which emits the electron beam 9 toward the substrate 1 is arranged in the bell jar 3.

Under the use of this vacuum deposition equipment, silicon 11 evaporated from the vapor source 2 under the degree of vacuum in the order of $10^{-4}$ Torr, for example, are deposited as a-Si on the substrate 1 and at the same time, the thermoelectrons 9 emitted from the thermoelectron generator 10 with an energy of 500 eV, for example, are caused to act in the vicinity of the substrate 1 on the modifying gas introduced evenly into the bell jar 3. Activated gases or ionized gases (e.g. hydrogen ions) produced therefrom are introduced efficiently into the a-Si film attracted and deposited on the substrate 1 having the negative voltage, for example, and thereby the vacuum-deposited film of a-Si:H wherein free bonds are taken up can be obtained. Hydrogen-containing a-Si, for example, thus obtained has sufficient dark-conductivity and photosensitivity and further has a uniform film quality whose dispersion is small.

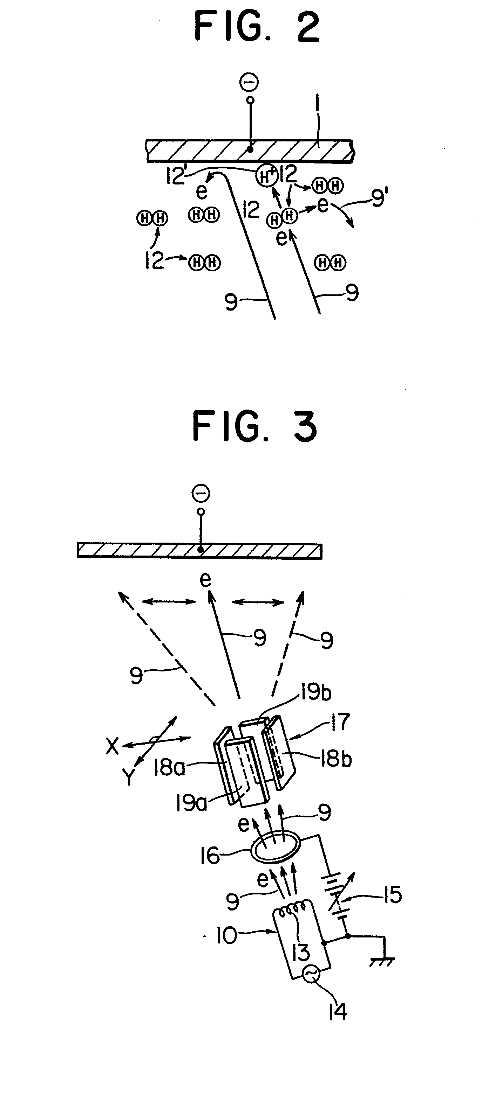

In Fig. 2, the state wherein hydrogen gases 12 as modifying gas are ionized (or activated) by thermoelectrons 9 in the vicinity of the substrate 1 is theoretically illustrated. Namely, thermoelectrons 9 emitted from the aforesaid thermoelectron generator 10 collide against hydrogen molecules 12 and the energy therefrom dissociate (ionize) the hydrogen molecules into hydrogen ions 12' and the hydrogen ions 12' thus produced are attracted to the substrate 1 having a negative voltage thereon and they are concurrently incorporated efficiently into the a-Si film deposited on the substrate 1. The thermoelectrons 9 which do not collide against the hydrogen molecules (and electrons 9' after collision), on the other hand, are repelled as illustrated when the voltage on the substrate 1 is properly set and therefore, they do not bombard the a-Si film. Therefore, the a-Si:H film deposited on the substrate 1 does not suffer the irradiation damage caused by the collision with electrons and thereby the quality of the film can be improved.

It is preferable that the thermoelectron generator 10 is actually constituted in a manner illustrated in Fig. 3. Namely, an AC voltage 14 (or DC voltage) is impressed on the W-filament 13 and thereby the thermoelectrons 9 having the energy of 500 eV are generated therefrom and an accelerating electrode 16 in

- 11 -

the form of a ring for example connected through the DC variable power source 15 to the other side is arranged above the W-filament 13. Since the accelerating electrode 16 is given a positive potential thereon, it attracts the thermoelectrons 9 from the filament 13 toward itself and accelerates them to a sufficient speed. Further, it is preferable that the electrons thus accelerated are deflected by such as an electric field deflecting device 17 for example in the directions of right and left and/or back and forth (X- and Y-directions) and their advancing paths are changed so that they scan evenly the surface of the substrate 1. Thereby, electron beams 9 scan the substrate surface uniformly and modifying gases can be activated or ionized in the vicinity of the substrate surface more uniformly from the positional viewpoint and therefore the distribution of hydrogen atoms etc. in the a-Si:H film thus obtained becomes uniform and the film characteristics are excessively improved. Incidentally, the deflecting device 17 is composed of two pairs of deflecting electrodes 18a, 18b and 19a, 19b arranged in the directions of X and Y with each pair in each direction and between electrodes of each pair, a definite AC power source (unillustrated) is connected and it is so composed that electron beams 9 are deflected to a definite direction by the impression of AC voltage. In this case, the electron beams 9 can easily be deflected because they consist of light particles. On the contrary, a high voltage is re-

0095384

- 12 -

quired when hydrogen ions are deflected as stated above and consequently it is not so practical because an arc discharge takes place.

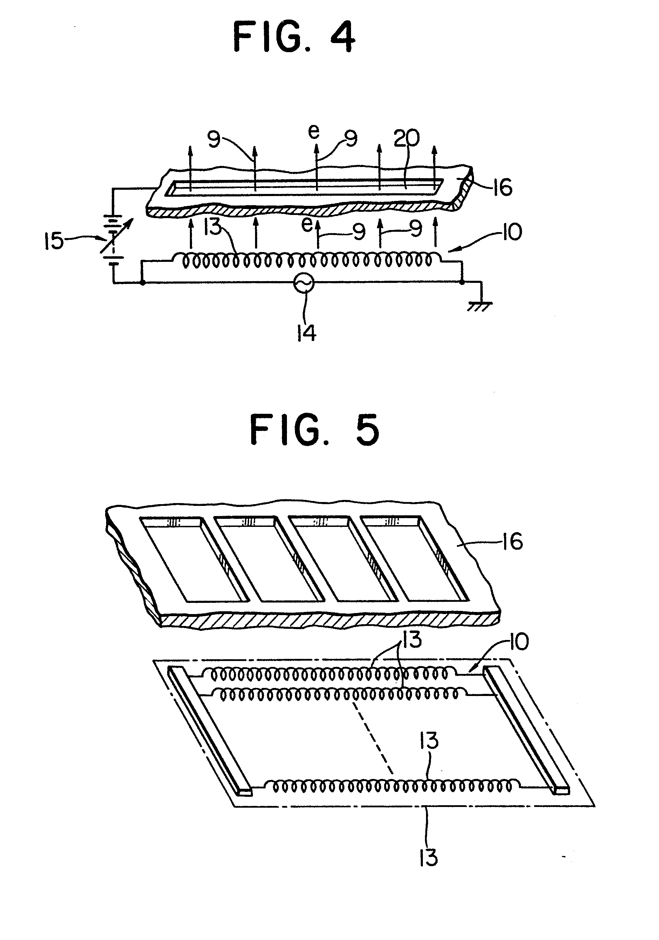

The thermoelectron generator 10 shown in Fig. 3 is of a type called a point type but other types such as a line type shown in Fig. 4 or a plane type shown in Fig. 5 can further be used as an electron generator. In the example of Fig. 4, electron beams 9 are emitted along the direction of the length of the W-filament 13 which is longer than that of Fig. 3 and they are further narrowed down to the line type parallel beam with a definite width after they pass through the slit 20 of the accelerating electrode 16. In this case, it is possible to operate so that the line type parallel beams 9, after they pass through the slit 20, are emitted in a line form to the substrate in the direction of X or Y in Fig. 3 and therefore it is possible to scan the substrate by the electron current uniformly despite the elimination of the pair of 18a and 18b or 19a and 19b of deflecting electrodes. Further, if the substrate 1 in the form of a rotating drum or a moving film is used instead of using the flat plate type in Fig. 1 - Fig. 3, aforesaid line type parallel beams can be emitted at a fixed position along the direction of the width of the drum or the film and hydrogen atoms etc. can be uniformly introduced into the vacuum-deposited film over the entire peripheral surface of the drum. The thermoelectron generator 10 in Fig. 5 has a plurality of W-filaments 13 arranged in parallel and it can emit electron beams covering the area corresponding such arranged area to the substrate through the accelerating electrode 16. The accelerating electrode 16 may be the one of various types such as a grid type or a mesh type etc. besides the one illustrated. In this case, therefore, the emission of electron beams is possible over the entire area of the substrate even if it is the one in the flat plate form and aforesaid deflecting device is not required. The filament 13 in Fig. 5 may be coiled in a spiral form to be a plane type that is the same as the one shown in Fig. 5. Further, the W-plate 13 whose external contour is shown with a chain line in Fig. 5 may be used as a plane type heater for generating thermoelectrons.

As illustrated above, the vacuum deposition equipment of the present example is constituted so that electron beams capable of being deflected easily and stably are emitted onto the substrate under the uniform supply of modifying gases and therefore hydrogen ions etc. may be introduced into the vacuum-deposited film uniformly and efficiently and further the film contamination caused by the re-evaporation etc. of impurities adhered can sharply be reduced because there is no influence of electron beams emission in the area other than the substrate.

Especially, by adjusting the gas pressure in a bell jar and the accelerating voltage for electron beams etc., it is possible to produce sufficiently the ions of modifying gases in

- 14 -

the vicinity of the substrate, which is extremely advantageous for causing hydrogen having a short excitation life to be incorporated efficiently into the vacuum-deposited film. Further, since no discharge tube described above is used, it is not necessary to provide the discharging section where the ion density and the current density are high and consequently there is no contamination from the equipment caused by sputtering etc.  In this connection, since there is no contamination from the equipment caused by the modifying gases decomposed by discharging, it is possible to select various modifying gases and thereby various application.

Various types of gas such as oxygen, nitrogen, halogen like fluorine, ammonia, monosilane, phosphine, diborane, arsine, hydrocarbon like methane and freon etc. can be used besides hydrogen or together with hydrogen as modifying gas suppliable in the present example.  Further, besides a-Si:H, the one composed of a-Ge:H, a-SiGe:H, a-SiC:H, a-SiGeC:H, a-Si:F, a-SiGe:F, a-SiC:F, a-SiGeC:F, $Si_3N_4$, $SiO_2$, $SnO_2$, $In_2O_3$, MgF and $Al_2O_3$ may be deposited as a vacuum-deposited film and for this purpose, the corresponding evaporation source and modifying gas have only to be selected.

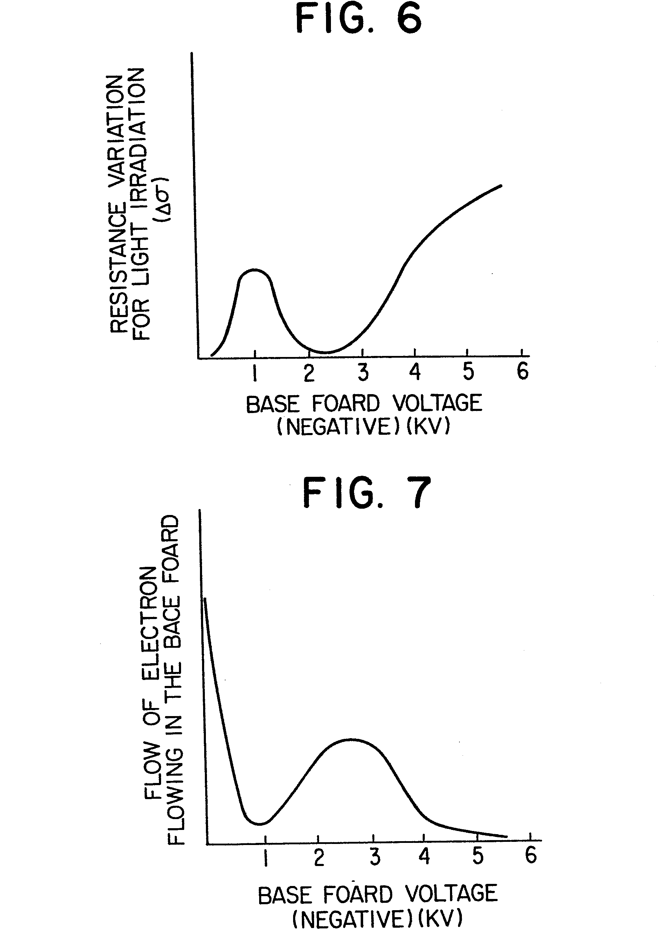

The inventors of the present invention have found that the electrical characteristic of the vacuum-deposited film obtained by using the equipment of the present example, of a-Si:H film, for example, shows the tendency indicated in Fig. 6 in the relation with the substrate voltage. According to this, as the negative substrate voltage grows greater in its absolute value, $\Delta\sigma$ starts dropping at the point of -1 KV or its vicinity and the photoconductivity (photosensitivity) may worsen but if the negative voltage grows greater in its absolute value, the photoconductivity improves. This is presumed that when the substrate voltage is negative, there exists the voltage range (especially -1 KV or its vicinity and the range beyond -4 KV) where the electron current is repelled and collision of electrons against the vacuum-deposited film is hindered but in the range of -2 - -4 KV, hydrogen ions created by the electron current are accelerated toward the substrate and they collide with hydrogen molecules which have not been ionized causing the ionization thereof and the production of secondary electrons and these secondary electrons bombard the a-Si:H film thereby the film characteristic (photoconductivity) is deteriorated. Fig. 7 shows the result of measurement wherein the tendency of Fig. 6 is converted to the electron current (amount of current) flowing in the substrate and both of them correspond each other.

From the results of both Fig. 6 and Fig. 7, it is understood that the vacuum-deposited film in good quality will be obtained if the operation is made under the optimum conditions (especially, the substrate voltage) wherein no electron current will flow in the substrate. Incidentally, the negative substrate voltage, as it grows greater in its absolute value, generally gives better results but if it exceeds -10 KV, the arc discharge tends to happen and therefore it is preferable that the negative substrate voltage is kept within -10 KV.

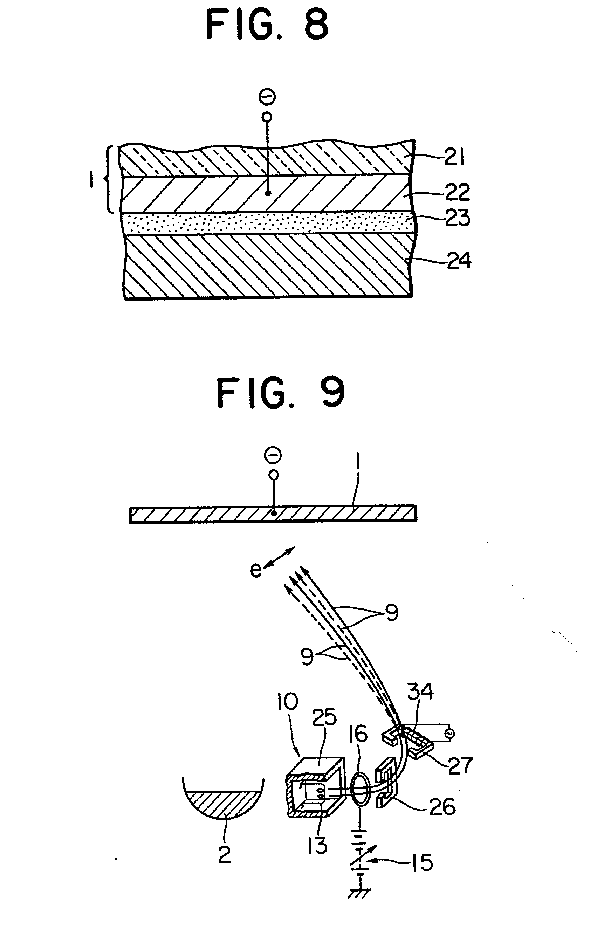

Incidentally, as shown in Fig. 8, there is a case where the insulation layer 23 is formed in advance on the substrate 1 at the side of evaporation source and on this layer, the a-Si:H film 24 is deposited by aforesaid vacuum deposition equipment. For example, the glass substrate 21 having the gate electrode 22 formed thereon is used as a substrate 1 and on this layer, the $SiO_2$ film 23 as a gate oxide film and an a-Si semiconductor layer 24 having source and drain areas at both sides thereof and having the face of the gate electrode 1 as a channel portion are laminated and thereby MISFET (Metal Insulator Semiconductor Field Effect Transistor) is prepared. In this case, since there exists the insulator layer 34 during the deposition of the a-Si:H film 24, the electric charges created by hydrogen ions are accumulated (charged up) and thereby the discharge inside the layer takes place and the a-Si:H film 24 is damaged. On the present example, however, it is possible to neutralize a certain amount of hydrogen ions on the substrate with electrons arrived therein by setting the substrate voltage to the optimum negative voltage so that a certain amount of electrons can arrive at the substrate. Thereby, it is possible to control charging up on the substrate

- 17 -

and prevent effectively the discharge inside the layer. Incidentally, the structure shown in Fig. 8 can be applied even as a photoreceptor for the electrophotography wherein the. insulation layer 23 is a blocking layer.

Fig. 9 shows an example wherein a shielding plate 25 for shielding the filament 13 of the thermoelectron generating device 10 from the vapor source 2 is provided and further the magnet 26 and the magnet 27 having an AC driving coil 34 both of which deflect or direct magnetically the emitted thermoelectrons 9 toward the substrate are provided together with the scanning function given thereto.

Owing to this example, the shielding plate 25 can prevent that the silicon vapor, for example, from the vapor source 2 adhere to the W-filament 13 and the like during the vacuum deposition. On the contrary, when there is no shielding plate 25, the silicon vapor adhere to the filament 13 and form tungsten-silicide which re-evaporate and thereby tungsten fly toward the substrate and are incorporated into the vacuum-deposited film and thereby cause the film quality to be deteriorated.

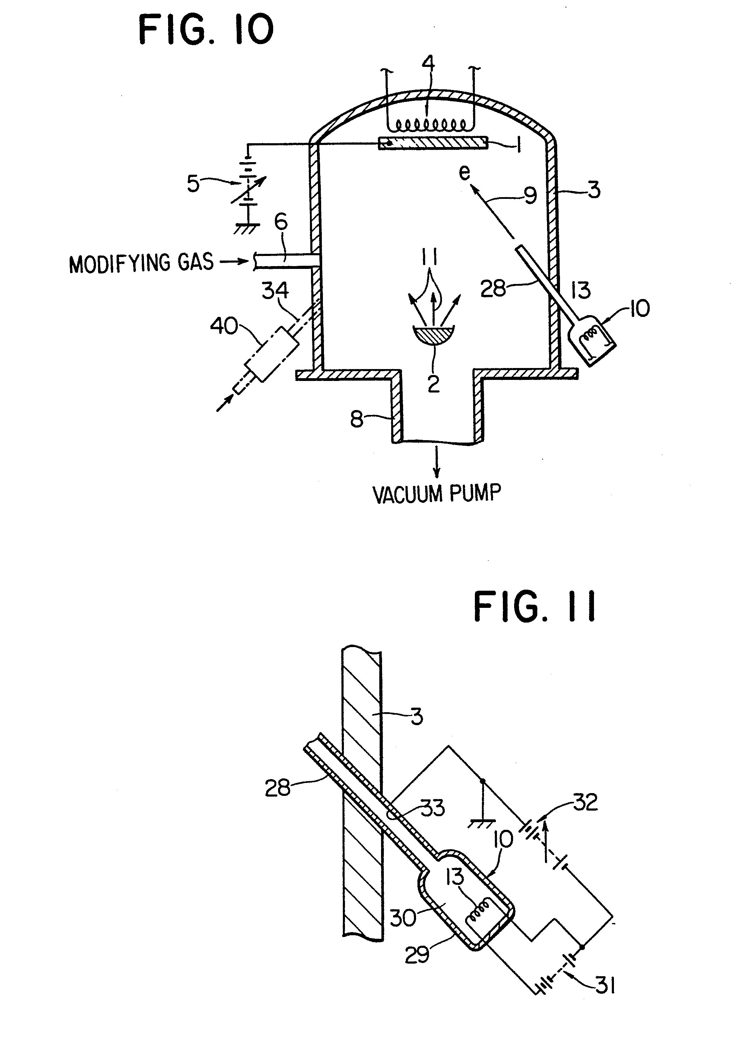

Fig. 10 and Fig. 11 show a vacuum deposition equipment of another example.

In this example, it is constituted that the filament (heater) portion 13 of aforesaid thermoelectron generator 10 is arranged outside of the bell jar 3 and electron beams 9 are emitted to the substrate surface through the inducing pipe 28 that extends toward the substrate 1. In this thermoelectron generator 10, the filament 13 is arranged in the electron-beam generating chamber 30 surrounded by a glass wall 29 and this filament is heated by the DC power source 31. And the inducing pipe 28 extends through the wall of the bell jar and the accelerating electrode 33 connected to the DC variable power source 32 is provided on the internal peripheral surface of the inducing pipe locating near the external surface of the bell jar.

Therefore, since the filament 13 of the electron-beam generator 10 is in a position that it is isolated from the inside of the bell jar 3, it is possible to eliminate effectively aforesaid contamination caused by the adherence of the vapor evaporated from the vapor source.

Incidentally, it is still possible to attain basically the object of the present invention even if the DC or AC type discharge tube 40 shown with a chain line in Fig. 10 is provided outside of the bell jar 3 in place of aforesaid thermoelectron generator 10 and even if the electrons generated in the discharge tube 40 are supplied from the inducing pipe 34 toward the substrate 1. Such discharge tube, though not illustrated, can be the one wherein the cylindrical electrode having the negative voltage at the entrance side and the cylindrical electrode having the positive voltage at the exit side are con-

nected by the water cooling pipe and thereby the supplied gases are discharged and electrons produced therefrom are guided into the bell jar 3 from the exit side through the inducing pipe 34.

In this vacuum deposition equipment, since the discharge tube 40 is arranged outside of the bell jar 3, contamination is sharply reduced compared with the case wherein it is arranged inside of the bell jar 3 and it does not take place that the electrode of the discharge tube and constituent materials are damaged by the heat and/or gas in the bell jar in operation. Therefore, the degree of freedom for the selection of materials of discharge tube is extended and its construction and layout can be done freely. Further, the structure of the water cooling pipe (unillustrated) for cooling in the discharge tube is easy to be designed, its cooling efficiency is satisfactory and the replacement of discharge tubes can easily be done outside the bell jar. On the point of sending in the electron beams, however, the discharge tube can naturally be arranged inside the bell jar.

Based upon the technical concept of the present invention, aforesaid examples can be varied in many ways.

The electrode (heater) to be used in the thermoelectron generator, for example, can employ lanthanumboride or the like besides tungsten and its layout can also be various. Further, aforesaid deflecting device can be either the one with an electric field or the one with a magnetic field or the one with

- 20 -

both of them. A negative voltage to be impressed on the substratecan be selected variously and its voltage can be varied with the lapse of time. The heating method for the evaporation source may be of a resistance-heating system in place of an electron beam system. Incidentally, besides aforesaid incorporating of hydrogen ions, the present invention may naturally be applied to the case wherein impurities are incorporated into the vacuum-deposited film through the usage of aforesaid various types of modifying gases or various types of vacuum-deposited films are formed.

- 21 -

# C L A I M S

1. Vacuum deposition apparatus including a chamber (3), a vapor source (2), a deposition substrate (1) opposite to the vapor source (2) and an inlet (6) for a modifying gas, wherein in use the vapor source (2) is heated in the presence of a modifying gas to be deposited onto the substrate, characterized by an electron-beam supplying device (10,40) for emitting an electron-beam toward the substrate (1).

2. Apparatus according to claim 1 or 2 characterized in that the electron-beam supplying device is a thermoelectron generator (10) or a gas discharge tube (40).

3. Apparatus according to claim 1 or 2 characterized by an electron-beam accelerating device (16).

4. Apparatus according to claim 1, 2 or 3 characterized by a magnetic field-deflecting device (26,27) or an electric field-deflecting device (18,19).

5. A vacuum deposition method for formation of a layer wherein a vapor source is heated in the presence of a modifying gas to be deposited onto a substrate opposite to the vapor source, characterized in that an electron-beam is generated and directed toward the substrate.

6. A method according to claim 5 characterized in that the layer is an amorphous silicon layer.

7. A method according to claim 5 or 6 characterized in that a negative voltage, preferably a DC voltage of 0 to -10 KV is applied to the substrate.

- 22 -

8. A method according to claim 5, 6 or 7 characterized in that the modifying gas is selected from the group consisting of hydrogen, oxygen, nitrogen, halogen, ammonia, monosilane, phosphine, diboran, allicin, hydrocarbons and olefins.

9. A method according to claim 5, 6, 7 or 8 characterized in that the electron-beam is accelerated by an accelerating device.

10. A method according to any one of claims 5 to 9 characterized in that the electron-beam is made to scan the substrate.

FIG. I

0095384

1/6

MODIFYING GAS →

→ VACUUM PUMP

# FIG. 2

# FIG. 3

# FIG. 4

# FIG. 5

# FIG. 6

RESISTANCE VARIATION FOR LIGHT IRRADIATION ($\Delta\sigma$)

BASE FOARD VOLTAGE (NEGATIVE) (KV)

# FIG. 7

FLOW OF ELECTRON FLOWING IN THE BACE FOARD

BASE FOARD VOLTAGE (NEGATIVE) (KV)

# FIG. 8

# FIG. 9

# FIG. 10

MODIFYING GAS →

VACUUM PUMP

# FIG. 11